(19) Europäisches Patentamt / European Patent Office / Office européen des brevets

(11) **EP 4 191 732 B1**

(12) **EUROPEAN PATENT SPECIFICATION**

(45) Date of publication and mention
of the grant of the patent:
**18.02.2026 Bulletin 2026/08**

(21) Application number: **20947705.8**

(22) Date of filing: **29.07.2020**

(51) International Patent Classification (IPC):
*H01M 10/42* (2006.01)    *H02J 7/00* (2026.01)
*G01R 31/389* (2019.01)    *G01R 31/392* (2019.01)
*H01M 10/48* (2006.01)

(52) Cooperative Patent Classification (CPC):
**H02J 7/84; G01R 31/389; G01R 31/392;
H01M 10/42; H01M 10/425; H01M 10/48;
H01M 10/482; H01M 10/486;** G01R 31/3842;
H01M 2010/4271; H02J 7/82; Y02E 60/10

(86) International application number:
**PCT/JP2020/028961**

(87) International publication number:
**WO 2022/024235 (03.02.2022 Gazette 2022/05)**

(54) **BATTERY MANAGEMENT DEVICE, BATTERY MANAGEMENT METHOD**

BATTERIEVERWALTUNGSVORRICHTUNG, BATTERIEVERWALTUNGSVERFAHREN

DISPOSITIF DE GESTION DE BATTERIE, PROCÉDÉ DE GESTION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.06.2023 Bulletin 2023/23**

(73) Proprietor: **HITACHI HIGH-TECH CORPORATION
Tokyo 105-6409 (JP)**

(72) Inventors:
• **MIFTAHULLATIF, Emha Bayu
Tokyo 100-8280 (JP)**
• **KOUNO, Toru
Tokyo 100-8280 (JP)**
• **FUJIMOTO, Hiroya
Tokyo 105-6409 (JP)**

• **UEDA, Yutaka
Tokyo 105-6409 (JP)**
• **FUKUZUKA, Tomoya
Tokyo 105-6409 (JP)**
• **OZAWA, Chiaki
Tokyo 105-6409 (JP)**

(74) Representative: **MERH-IP Matias Erny Reichl
Hoffmann
Patentanwälte PartG mbB
Paul-Heyse-Straße 29
80336 München (DE)**

(56) References cited:
WO-A1-2017/169088    WO-A1-2019/240225
JP-A- 2008 292 272    JP-A- 2009 288 039
JP-A- 2014 025 738    JP-A- 2018 205 309
JP-A- 2018 205 309    JP-A- 2020 003 218
JP-A- H04 215 083    US-A1- 2018 321 323

**Description**

Technical Field

The present invention relates to a technique for managing a state of a battery.

Background Art

The number of storage batteries in the market continues to increase. When a battery deteriorates, a total charge capacity thereof decreases. This state is expressed as a state of health (SOH) of the battery. When the battery deteriorates, an internal resistance Ri of the battery also increases. By evaluating a battery state based on SOH and Ri, it is possible to determine an appropriate use case.

An object of the following PTL 1 is to "provide a battery internal resistance component estimation method that can improve accuracy of an estimated value of an internal resistance and thus improve calculation accuracy of SOC that is a battery capacity". PTL 1 discloses a technique that is "a method for estimating an internal resistance component of a battery 5 implemented by a plurality of unit cells, in which diffusion polarization resistance, in consideration of a voltage generated due to uneven distribution caused by diffusion movement of an ionic substance inside the battery 5, is set as the internal resistance component of the battery 5, and the diffusion polarization resistance is estimated using a change over time in a concentration of the diffused substance" (see Abstract).

An object of the following PTL 2 is to "accurately estimate SOC and SOH in consideration of not only a process value of a battery but also a cross-correlation between SOC and SOH". PTL 2 discloses a technique in which "in a battery controller 6BC, a BCIA 9 includes an internal resistance measurement unit 96 that measures a 25 °C conversion value R25 of an internal resistance of a battery 5 and an open circuit voltage measurement unit 97 that measures a 25 °C conversion value OCV25 of an open circuit voltage, and a CPU 8 includes an equation storage unit 86 that stores a first equation representing a relationship between OCV25, SOH and SOC and a second equation representing a relationship between R25, SOH and SOC, and a solution unit 87 that applies measurement results of R25 and OCV25 to the respective equations so as to obtain SOH and SOC as solutions of the simultaneous equations" (see Abstract).

An object of the following PTL 3 is to "provide a battery system 1 having a simple configuration for evaluating characteristics of a secondary battery 10". PTL 3 discloses a technique in which "the battery system 1 includes: the secondary battery 10 including a positive electrode 11, a negative electrode 15, and electrolytes 12 and 14; a storage unit 23 that stores specific information of the secondary battery 10 measured in advance including an initial resistance value and an evaluation frequency; a power supply unit 20 that applies an AC signal of the evaluation frequency stored in the storage unit 23 to the secondary battery 10; a measurement unit 22 that measures an impedance of a solid electrolyte interface film 17 of the secondary battery 10 based on the AC signal; and a calculation unit 24 that calculates at least one of a deterioration degree and a depth of discharge of the secondary battery 10 based on the impedance and the specific information" (see Abstract).

PTL 4 discloses a calculation section which calculates a residual capacity estimated value of a battery module by using an integration result of a measured current value of the battery module.

PTL 5 discloses a management device for managing an electricity storage element, an electricity storage module, a management method, and a computer program.

Citation List

Patent Literature

PTL 1: JP-A-2010-175484
PTL 2: JP-A-2017-129401
PTL 3: JP-A-2013-088148
PTL 4: JP 2014 025738 A
PTL 5: JP 2018 205309 A

Summary of Invention

Technical Problem

In PTL 1, since only the internal resistance is measured, a technique for measuring SOH is separately required. In PTL 2, Ri and SOH are measured using an open circuit voltage (OCV). However, the method using OCV tends to take a long measurement time. In PTL 3, a waveform generator that generates a waveform for measuring the impedance is separately required.

The invention has been made in view of the above problems, and an object thereof is to provide a technique that enables an internal resistance and a state of health of a battery to be measured at the same time in a short time by a simple method.

Solution to Problem

The above cited problem is solved in accordance with the appended set of claims. A battery management device according to the invention acquires a first difference between the voltage at a first start time point after an end time point when charging or discharging is ended and the voltage at a first time point when a first period elapses after the first start time point, further acquires a second difference between the voltage at a second start time point after the first time point and the voltage at a second time point when a second period elapses after the second start time point, estimates an internal resistance according to a relationship between the first difference and the internal resistance of the battery, and estimates a state of health according to a relationship between the second difference and the state of health of the battery.

Advantageous Effects of Invention

According to the battery management device according to the invention, the internal resistance and the state of health of the battery can be measured at the same time in a short time. Other problems, advantages, configurations, and the like of the invention will become apparent from the following description of embodiments.

Brief Description of Drawings

[FIG. 1] FIG. 1 is a diagram showing variations in an internal resistance (Ri) and a state of health (SOH) of a battery.
[FIG. 2] FIG. 2 is a schematic diagram showing an application of a battery management device.
[FIG. 3] FIG. 3 is a diagram showing a configuration example of a battery management device 100 according to Embodiment 1.
[FIG. 4] FIG. 4 is a diagram showing another configuration example of the battery management device 100.
[FIG. 5] FIG 5 shows a configuration example in a case where a detection unit 130 is connected to a battery 200.
[FIG. 6] FIG. 6 is a flowchart showing a procedure through which a calculation unit 120 calculates an Ri and an SOH.
[FIG. 7] FIG. 7 is a graph showing changes over time in a current and a voltage output from the battery 200 in a pause period after discharging.
[FIG. 8] FIG. 8 is a graph showing changes over time in the current and the voltage output from the battery 200 in a pause period after charging.
[FIG. 9] FIG. 9 is a diagram showing an example of a configuration and data of a relationship table 141.
[FIG. 10] FIG. 10 is a diagram showing a configuration example of the relationship table 141 according to Embodiment 2.

Description of Embodiments

<Embodiment 1>

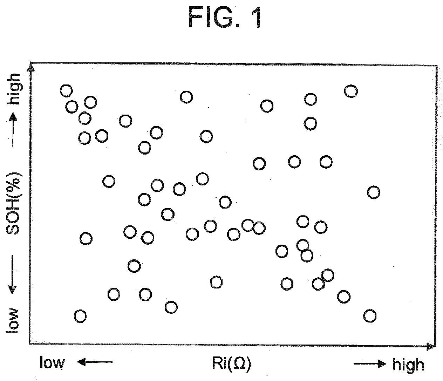

FIG. 1 is a diagram showing variations in an internal resistance (Ri) and a state of health (SOH) of a battery. Depending on Ri and SOH, an appropriate use method, application, or the like may be different. Therefore, it is important to measure Ri and SOH during operation management of the battery.

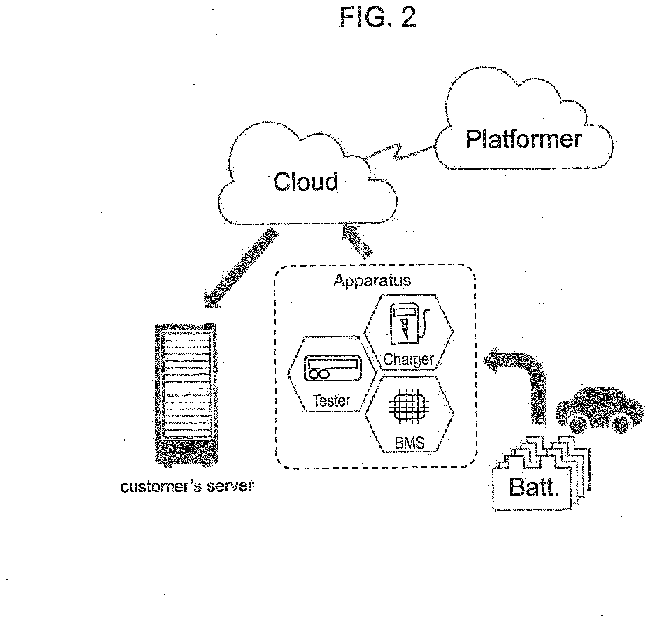

FIG. 2 is a schematic diagram showing an application of a battery management device according to the invention. A battery (for example, a battery cell, a battery module, or a battery pack) that needs to be charged and discharged is connected to various devices. Examples thereof include a tester, a battery management system (BMS), and a charger. When the battery is connected to these devices, the battery is in one of a charging operation, a discharging operation, and a pause state. Ri and SOH can be calculated, for example, on the above-described device or on a computer connected via a network such as on a cloud server, depending on where an algorithm for calculating Ri and SOH is performed. An advantage of calculation on the device to which the battery is connected is that a battery state (a voltage output from the battery, a current output from the battery, a temperature of the battery, and the like) can be acquired at a high frequency;

Ri and SOH calculated on a cloud system can also be transmitted to a computer owned by a user. The user computer can provide the data for a specific purpose such as inventory management. Ri and SOH calculated on the cloud system can be stored in a database of a cloud platform provider and used for other purposes. Examples thereof include optimization of a replacement path of an electric vehicle and energy management.

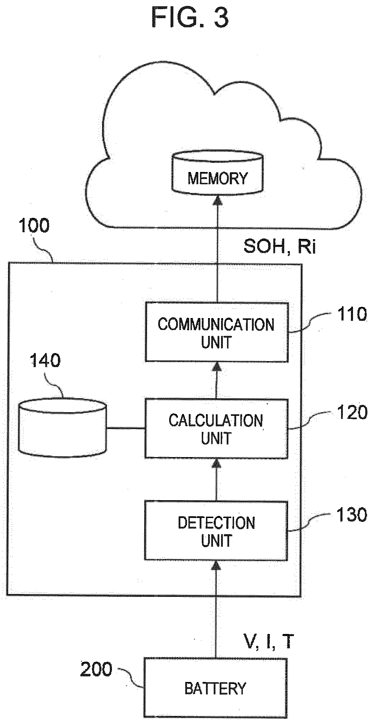

FIG. 3 is a diagram showing a configuration example of a battery management device 100 according to Embodiment 1 of the invention. In FIG. 3, the battery management device 100 is a device that is connected to a battery 200 and receives power supplied from the battery 200, and corresponds to the tester or the like in FIG. 2. The battery management device 100 includes a communication unit 110, a calculation unit 120, a detection unit 130, and a storage unit 140.

The detection unit 130 acquires a detected value V of a voltage output from the battery 200 and a detected value I of a current output from the battery 200. Further, as an option, a detected value T of a temperature of the battery 200 may also be acquired. These detected values may be detected by the battery 200 and notified of to the detection unit 130, or may be detected by the detection unit 130. Details of the detection unit 130 will be described later.

The calculation unit 120 estimates Ri and SOH of the battery 200 using the detected values acquired by the detection unit 130. An estimation procedure thereof will be described later. The communication unit 110 transmits R and SOH estimated by the calculation unit 120 to the outside of the battery management device 100. For example, Ri and SOH can be transmitted to a memory provided in a cloud system. The storage unit 140 stores a data table to be described later.

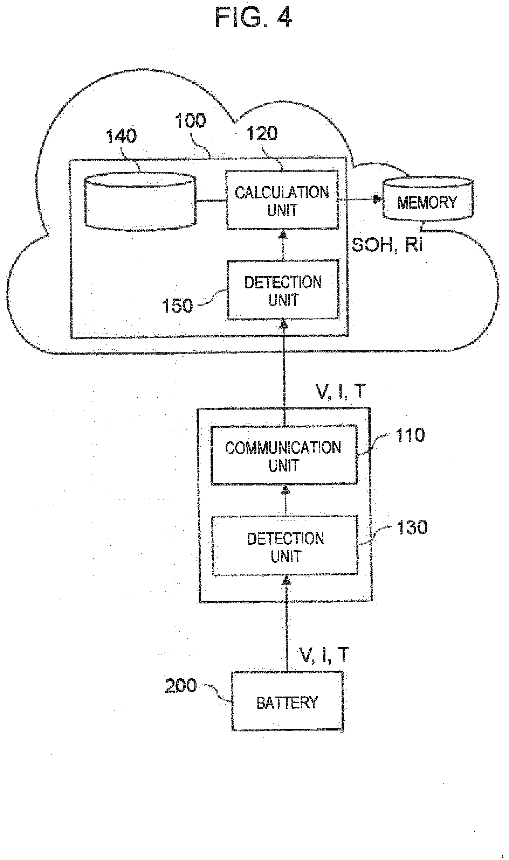

FIG. 4 is a diagram showing another configuration example of the battery management device 100. The battery management device 100 does not necessarily have to be a device that is directly connected to the battery 200 and receives power supply, and may be shown in a form that does not include the communication unit 110 and the detection unit 130 shown in FIG. 3. In FIG. 4, the battery management device 100 acquires the voltage V, the current I, and the temperature T of the battery 200 from the communication unit 110. Specifically, a detection unit 150 provided in the battery management device 100 receives these detected values via, for example, a network, and the calculation unit 120 calculates Ri and SOH using these detected values.

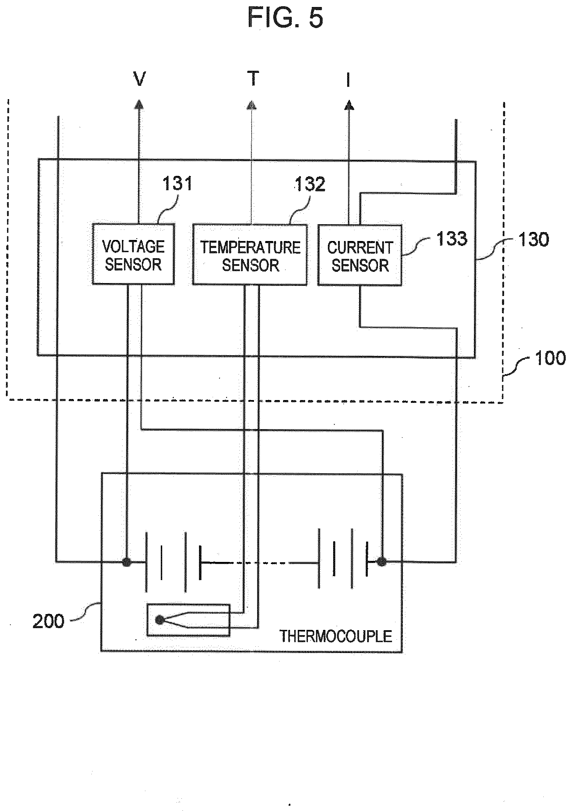

FIG. 5 shows a configuration example in a case where the detection unit 130 is connected to the battery 200. The detection unit 130 may be configured as a part of the battery management device 100, or may be configured as a module separate from the battery management device 100. The detection unit 130 includes a voltage sensor 131, a temperature sensor 132, and a current sensor 133 in order to acquire the voltage V, the temperature T, and the current I during a charging and discharging operation of the battery 200.

The voltage sensor 131 measures a voltage across the battery 200 (the voltage output from the battery 200). The temperature sensor 132 is connected to, for example, a thermocouple provided in the battery 200, and measures the temperature of the battery 200 via the thermocouple. The current sensor 133 is connected to one end of the battery 200 and measures the current output from the battery 200. The temperature sensor 132 is optional and may not necessarily be provided.

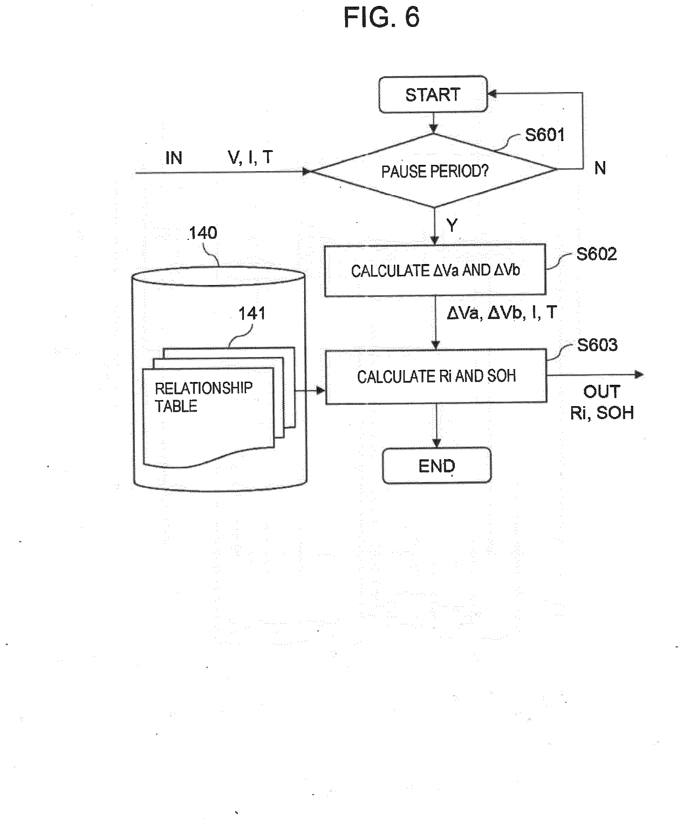

FIG. 6 is a flowchart showing a procedure through which the calculation unit 120 calculates Ri and SOH. For example, when the battery management device 100 is activated, when the calculation unit 120 is instructed to start the present flowchart, the calculation unit 120 starts the present flowchart at an appropriate timing such as every predetermined period. Each step in FIG. 6 will be described below.

(FIG. 6: Step S601)

The calculation unit 120 determines whether or not a current period is a pause period after charging or a pause period after discharging. If the current period is not a pause period, the present flowchart is ended. If the current period is a pause period, the process proceeds to S602. For example, the fact that the current period is the pause period after discharging can be determined when the current output from the battery 200 changes from a negative value (I < 0) toward zero, or when (b) changes from a negative value to a value near zero and becomes stable (|I| < threshold value).

(FIG. 6: Step S602)

The calculation unit 120 calculates ΔVa and ΔVb. ΔVa is a variation in the output voltage of the battery 200 from a first start time point after an end of the pause period to a first time point when a first period ta elapses. ΔVb is a variation in the output voltage of the battery 200 from a second start time point after the first time point to a second time point when a second period tb elapses. These calculation procedures will be described later.

(FIG. 6: Step S603)

The calculation unit 120 calculates Ri and SOH according to the following equations 1 and 2. $f_{Ri}$ defines Ri as a function of ΔVa. $f_{Ri}$ includes a parameter ($c\_Ri\_T$) that varies according to the temperature of the battery 200, and a parameter ($c\_Ri\_I$) that varies according to the output current of the battery 200. $f_{SOH}$ defines SOH as a function of ΔVb.

$f_{SOH}$ includes a parameter (c_SOH_T) that varies according to the temperature of the battery 200, and a parameter (c_SOH_I) that varies according to the output current of the battery 200. These parameters are defined by a relationship table 141. A specific example of each function and a specific example of the relationship table 141 will be described later. $f_{Ri}$ and $f_{SOH}$ are, for example, equations formed based on experimental data for each lot.

(FIG. 6: Step S604: Calculation Equation)

$$Ri = f_{Ri}(\Delta Va, c\_Ri\_T\_1, c\_Ri\_T\_2, ..., c\_Ri\_I\_1, c\_Ri\_I\_2, ...) \qquad (1)$$

$$SOH = f_{SOH}(\Delta Vb, c\_SOH\_T\_1, c\_SOH\_T\_2, ..., c\_SOH\_I\_1, c\_SOH\_I\_2, ...) \quad (2)$$

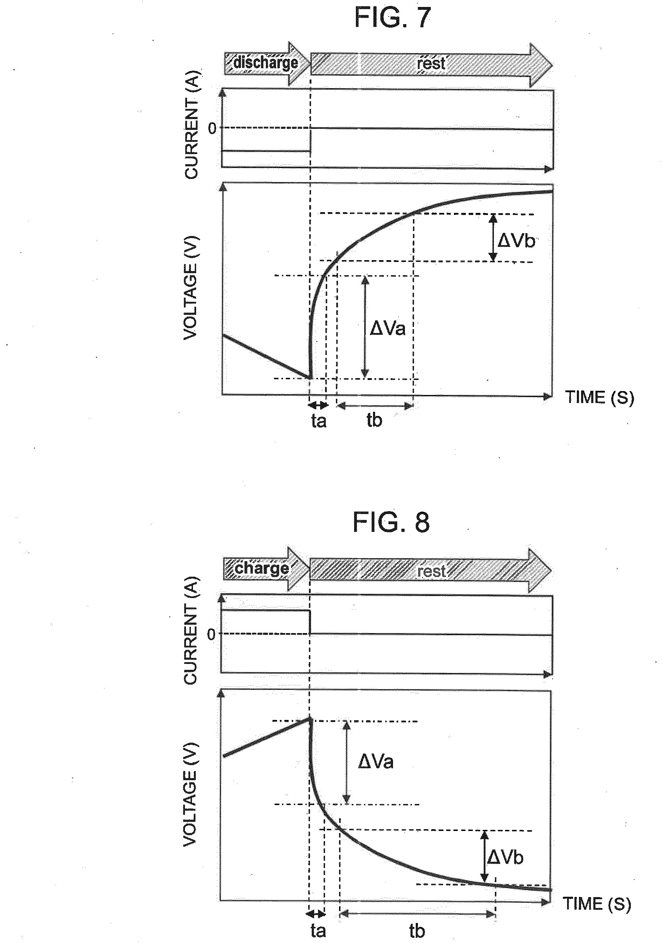

FIG. 7 is a graph showing changes over time in the current and the voltage output from the battery 200 in the pause period after discharging. $\Delta Va$ in S602 is a variation in the output voltage of the battery 200 from the first start time point which is a time point when the discharging ends or a time point thereafter to the first time point when the first period ta elapses. The inventors of the invention have found that the voltage variation caused by the internal resistance of the battery 200 appears well in the output voltage immediately after the end of discharging. That is, it can be said that the variation ($\Delta Va$) in the output voltage in this period has a strong correlation with Ri. In Embodiment 1, Ri is estimated based on $\Delta Va$ using this fact. Optimum values of a start time point and a time length of ta can be acquired based on a section from after the end time point of the discharging to a maximum point of a slope rate-of-change in a change over time curve of the voltage. It should be noted that, when the section is specified, the vicinity of both ends of the section or a region including the both ends may be appropriately used depending on a type of the battery, devices, accuracy, and the like.

$\Delta Vb$ in S602 is a variation in the output voltage of the battery 200 from the second start time point which is a time point when the period ta elapses or a time point thereafter to the second time point when the second period tb elapses. The present inventors have found that $\Delta Va$ immediately after the end of discharging has a correlation with Ri, whereas a period thereafter in which the output voltage gradually changes has a correlation with SOH. In Embodiment 1, SOH is estimated based on $\Delta Vb$ using this fact. Optimum values of a start time point and a time length of tb can be acquired based on a section from the maximum point of the slope rate-of-change in the change over time curve of the voltage after the end time point of the discharging to a point where a change in slope of the change over time curve of the voltage asymptotically approaches a constant value. It should be noted that, when the section is specified, the vicinity of both ends of the section or a region including the both ends may be appropriately used depending on the type of the battery, devices, accuracy, and the like.

The start time point of ta may not necessarily be the same as the end time point of discharging, and is preferably close to the end time point of discharging. The start time point of tb may not necessarily be the same as the end time point of ta. In either case, ta and tb have a relationship of ta < tb. As for magnitude of $\Delta Va$ and magnitude of $\Delta Vb$, $\Delta Va$ may be larger than $\Delta Vb$, or $\Delta Vb$ may be larger than $\Delta Va$. Although ta < tb is set here, ta > tb or ta = tb may also be set depending on the type of the battery, devices, accuracy, and the like, and thus a preferable relationship may be set as appropriate.

The present inventors have found from experimental results that Ri and SOH can be accurately estimated even when a sum of ta and tb is, for example, about several seconds. Therefore, according to Embodiment 1, Ri and SOH can be quickly estimated in the pause period.

FIG. 8 is a graph showing changes over time in the current and the voltage output from the battery 200 in the pause period after charging. $\Delta Va$ in S602 may be a variation in the output voltage of the battery 200 from the first start time point which is a time point when the charging, instead of discharging, ends of a time point thereafter to the first time point when the first period ta elapses. In this case, $\Delta Vb$ in S602 is a variation in the output voltage of the battery 200 from the second start time point which is a time point when the period ta elapses or a time point thereafter to the second time point when the second period tb elapses. The present inventors have found that $\Delta Va$ has a correlation with Ri whereas $\Delta Vb$ has a correlation with SOH also in the pause period after charging. Therefore, in Embodiment 1, $\Delta Va$ and $\Delta Vb$ in S602 may be acquired after either charging or discharging.

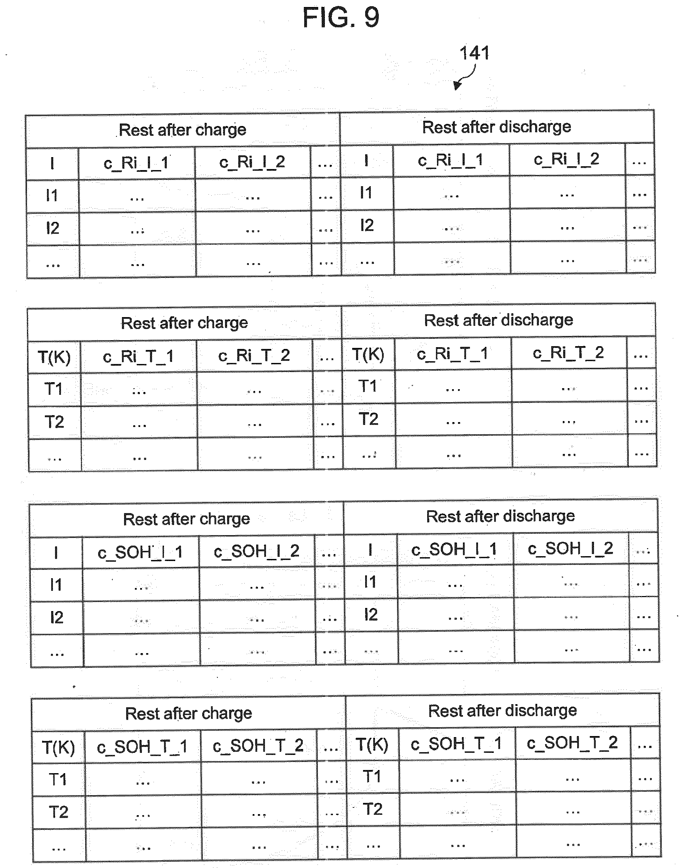

FIG. 9 is a diagram showing an example of a configuration and data of the relationship table 141. The relationship table 141 is a data table that defines each parameter in Equations 1 and 2. Since c_Ri_I and c_SOH_I vary according to the output current of the battery 200, c_Ri_I and c_SOH_I are defined for each output current value. Since c_Ri_T and c_SOH_T vary according to the temperature of the battery 200, c_Ri_T and c_SOH_T are defined for each temperature. Since these parameters may have different characteristics in the pause period after discharging and the pause period after charging, the relationship table 141 defines each parameter for each of these periods.

When $f_{Ri}$ is a linear function of $\Delta Va$, Ri can be expressed by, for example, the following Equation 3. This is because slope of Ri is affected by the temperature whereas an intercept is affected by the current. In this case, there is one c_Ri_T and one c_Ri_I.

$$Ri = c\_Ri\_T\_1 \times \Delta Va + c\_Ri\_I\_1 \quad (3)$$

When $f_{SOH}$ is a linear function of $\Delta Vb$, SOH can be expressed by, for example, the following Equation 4. This is because slope of SOH is affected by the temperature whereas the intercept is affected by the current. In this case, there is one c_SOH_T and one c_SOH_I.

$$SOH = c\_SOH\_T\_1 \times \Delta Vb + c\_SOH\_I\_1 \quad (4)$$

<Embodiment 1: Summary>

The battery management device 100 according to Embodiment 1 estimates Ri using the voltage variation $\Delta Va$ in the period ta and estimates SOH using the voltage variation $\Delta Vb$ in the period tb in the pause period after the end of discharging or the pause period after the end of charging. Accordingly, Ri and SOH can be estimated in a shorter time than in the related art.

In the battery management device 100 according to Embodiment 1, the relationship table 141 describes the internal resistance parameters defining the function $f_{Ri}$ representing the relationship between Ri and $\Delta Va$. The internal resistance parameters includes c_Ri_I that varies according to the output current of the battery 200 and c_Ri_T that varies according to the temperature of the battery 200. Accordingly, Ri can be accurately estimated even when the function $f_{Ri}$ varies according to the temperature of the battery 200 or the output current of the battery 200. The same applies to the state of health parameters that define the function $f_{SOH}$.

In the battery management device 100 according to Embodiment 1, the relationship table 141 describes the internal resistance parameters and the state of health parameters for each of the pause period after charging and the pause period after discharging. Accordingly, Ri and SOH can be accurately estimated even when the function (that is, the characteristics of the battery 200) is different in the pause period after charging and the pause period after discharging.

<Embodiment 2>

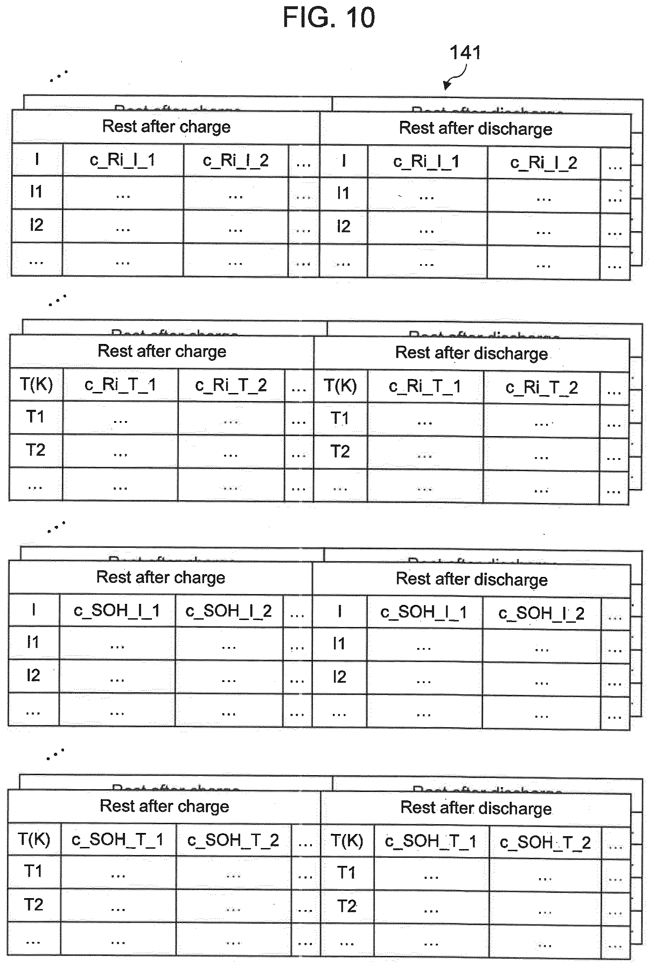

FIG. 10 is a diagram showing a configuration example of the relationship table 141 according to Embodiment 2 of the invention. In the relationship table 141 according to Embodiment 1, it is described that the parameters are defined for each of the pause period after charging and the pause period after discharging. In addition to this configuration, in the relationship table 141, these parameters may be defined for each manufacturing lot number of the battery 200. This is because the correlation between Ri and $\Delta Va$ and the correlation between SOH and $\Delta Vb$ may be different for each manufacturing lot. Therefore, FIG. 10 shows an example in which one data table is provided for each manufacturing lot number.

The calculation unit 120 acquires each parameter from a data table corresponding to the manufacturing lot number of the battery 200.

<Modification of Invention>

The invention is not limited to the embodiments described above, and includes various modifications without departing from the scope of the invention as defined in the appended claims. For example, the above-described embodiments have been described in detail for easy understanding of the invention, and the invention is not necessarily limited to those including all the configurations described above. In addition, a part of a configuration of one embodiment can be replaced with a configuration of another embodiment, and a configuration of one embodiment can be added to a configuration of another embodiment. In addition, a part of a configuration of each embodiment may be added to, deleted from, or replaced with another configuration.

In the above embodiment, it is described that $\Delta Va$ and $\Delta Vb$ are acquired during the pause period after discharging or the pause period after charging. The discharging or charging at this time may not necessarily be complete discharging (a remaining capacity of the battery 200 is 0) or complete charging (the battery 200 is fully charged). That is, the period may be any period after the end of the discharging operation or the charging operation.

In the above embodiment, the reason why $\Delta Va$ and $\Delta Vb$ are acquired during the pause period after discharging or the pause period after charging is that it is assumed that the output current of the battery 200 steeply rises immediately after the end of the discharging and the output current of the battery 200 steeply falls immediately after the end of the charging. For example, it is assumed that the current rises or falls in a rectangular wave shape. This is because it is considered that a voltage response of the battery 200 to various frequency components of the output current can be obtained when the output current has a rectangular wave. Therefore, it is desirable that the output current of the battery 200 varies in a rectangular wave shape in the pause period after discharging or the pause period after charging. However, the current waveform may not strictly be a rectangular wave, and may also be a current waveform approximate to a rectangular wave.

In the above embodiment, the linear function is exemplified as an example of each of the functions $f_{Ri}$ and $f_{SOH}$, and the functions may also be other functions. For example, a polynomial function of a quadratic function or a polynomial function of a higher degree may be used. In any case, parameters such as coefficients for defining the function may be described in the relationship table 141. Among the parameters, those that vary according to the output current of the battery 200 may be defined for each current value, and those that vary according to the temperature of the battery 200 may be defined for each temperature value.

In the embodiments described above, the calculation unit 120 and the detection unit 130 may be implemented by hardware such as a circuit device in which functions of the calculation unit 120 and the detection unit 130 are implemented, or may be implemented by a calculation device such as a central processing unit (CPU) executing software in which the functions of the calculation unit 120 and the detection unit 130 are implemented.

In the above embodiments, the storage unit 140 is not necessarily disposed on the same device as the calculation unit 120. That is, as long as the calculation unit 120 can acquire information defined by the relationship table 141 and store the information in a storage device such as a local memory, the relationship table 141 may be disposed on a device different from the calculation unit 120.

Reference Signs List

    100: battery management device
    110: communication unit
    120: calculation unit
    130: detection unit
    140: storage unit
    141: relationship table
    200: battery

**Claims**

1. A battery management device for managing a state of a battery (200), comprising:

    a detection unit (130) configured to acquire a detected value of a voltage output from the battery (200) and a detected value of a current output from the battery (200); and
    a calculation unit (120) configured to estimate an internal resistance of the battery (200) and a state of health of the battery (200) using a difference indicating a change over time in the voltage, wherein
    the calculation unit (120) acquires, as the difference, a first difference between the voltage at a first start time point after an end time point when charging or discharging of the battery (200) is ended and the voltage at a first time point when a first period elapses after the first start time point,
    **characterized in that**
    the calculation unit (120) acquires, as the difference, a second difference between the voltage at a second start time point after the first time point and the voltage at a second time point when a second period elapses after the second start time point, the calculation unit (120) acquires relationship data that describes a relationship between the first difference and the internal resistance and describes a relationship between the second difference and the state of health,
    the calculation unit (120) estimates the internal resistance using the first difference to refer to the relationship data, and
    the calculation unit (120) estimates the state of health using the second difference to refer to the relationship data.

2. The battery management device according to claim 1, wherein,

    in a voltage change curve after an end time point of charging or discharging, the first period is a section from after the end time point of charging or discharging to a maximum point of a slope rate-of-change of the voltage change curve, and

the second period is a section from the maximum point of the slope rate-of-change to a point at which a change in slope of the voltage change curve asymptotically approaches a constant value.

3. The battery management device according to claim 1, wherein

the relationship data describes an internal resistance parameter that defines an internal resistance function representing the relationship between the internal resistance and the first difference, the internal resistance parameter includes:

an internal resistance_temperature parameter that varies according to a temperature of the battery (200); and
an internal resistance_current parameter that varies according to the current,
the relationship data describes the internal resistance_temperature parameter for each value of the temperature of the battery (200) and describes the internal resistance_current parameter for each value of the current, and
the calculation unit (120) calculates the internal resistance using the internal resistance parameter acquired from the relationship data.

4. The battery management device according to claim 1, wherein

the relationship data describes a state of health parameter that defines a state of health function representing the relationship between the state of health and the second difference, the state of health parameter includes:

a state of health_temperature parameter that varies according to a temperature of the battery (200); and
a state of health_current parameter that varies according to the current,
the relationship data describes the state of health_temperature parameter for each value of the temperature of the battery (200) and describes the state of health_current parameter for each value of the current, and
the calculation unit (120) calculates the state of health using the state of health parameter acquired from the relationship data.

5. The battery management device according to claim 3, wherein

the internal resistance function is a function representing the relationship between the internal resistance and the first difference by a linear function of the first difference,
the internal resistance_temperature parameter defines a slope of the linear function for each value of the temperature of the battery (200),
the internal resistance_current parameter defines an intercept of the linear function for each value of the current,
the calculation unit (120) acquires the slope of the linear function using a measured value of the temperature of the battery (200) to refer to the relationship data,
the calculation unit (120) acquires the intercept of the linear function using a measured value of the current to refer to the relationship data, and
the calculation unit (120) calculates the internal resistance using the slope acquired from the relationship data and the intercept acquired from the relationship data.

6. The battery management device according to claim 4, wherein

the state of health function is a function representing the relationship between the state of health and the second difference by a linear function of the second difference,
the state of health_temperature parameter defines a slope of the linear function for each value of the temperature of the battery (200),
the state of health_current parameter defines an intercept of the linear function for each value of the current,
the calculation unit (120) acquires the slope of the linear function using a measured value of the temperature of the battery (200) to refer to the relationship data,
the calculation unit (120) acquires the intercept of the linear function using a measured value of the current to refer to the relationship data, and
the calculation unit (120) calculates the state of health using the slope acquired from the relationship data and the intercept acquired from the relationship data.

7. The battery management device according to claim 3, wherein

the relationship data describes the internal resistance parameter for each of a first pause period after charging of the battery (200) is ended and a second pause period after discharging of the battery (200) is ended,
the relationship data describes a post-charging parameter that defines the internal resistance parameter in the first pause period,
the relationship data describes a post-discharging parameter that defines the internal resistance parameter in the second pause period,
the calculation unit (120) acquires the post-charging parameter from the relationship data in the first pause period, and
the calculation unit (120) acquires the post-discharging parameter from the relationship data in the second pause period.

8. The battery management device according to claim 4, wherein

the relationship data describes the state of health parameter for each of a first pause period after charging of the battery (200) is ended and a second pause period after discharging of the battery (200) is ended,
the relationship data describes a post-charging parameter that defines the state of health parameter in the first pause period,
the relationship data describes a post-discharging parameter that defines the state of health parameter in the second pause period,
the calculation unit (120) acquires the post-charging parameter from the relationship data in the first pause period, and
the calculation unit (120) acquires the post-discharging parameter from the relationship data in the second pause period.

9. The battery management device according to claim 3, wherein

the relationship data describes the internal resistance parameter for each manufacturing lot number of the battery (200), and
the calculation unit (120) acquires the internal resistance parameter using the manufacturing lot number of the battery (200) to refer to the relationship data.

10. The battery management device according to claim 4, wherein

the relationship data describes the state of health parameter for each manufacturing lot number of the battery (200), and
the calculation unit (120) acquires the state of health parameter using the manufacturing lot number of the battery (200) to refer to the relationship data.

11. The battery management device according to claim 1, wherein

the battery (200) is configured such that the current rises in a rectangular wave shape when discharging is ended, or the current falls in a rectangular wave shape when charging is ended, and
the calculation unit (120) acquires a variation in the voltage caused due to the rising or the falling of the rectangular wave shape as at least a part of the first difference.

12. A battery management method configured to manage a state of a battery (200), comprising:

acquiring a detected value of a voltage output from the battery (200) and a detected value of a current output from the battery (200); and
estimating an internal resistance of the battery (200) and a state of health of the battery (200) using a difference indicating a change over time in the voltage, wherein
in the estimating, a first difference between the voltage at a first start time point after an end time point when charging or discharging of the battery (200) is ended and the voltage at a first time point when a first period elapses after the first start time point is acquired as the difference,
**characterized in that**
in the estimating, a second difference between the voltage at a second start time point after the first time point and the voltage at a second time point when a second period elapses after the second start time point is acquired as the difference,

in the estimating, relationship data that describes a relationship between the first difference and the internal resistance and describes a relationship between the second difference and the state of health is acquired,

in the estimating, the internal resistance is estimated using the first difference to refer to the relationship data, and

in the estimating, the state of health is estimated using the second difference to refer to the relationship data.

13. The battery management device according to claim 1, wherein a time interval exists between the first time point and the second start time point.

## Patentansprüche

1. Batterieverwaltungsvorrichtung zum Verwalten eines Zustands einer Batterie (200) umfassend:

   eine Erfassungseinheit (130), die konfiguriert ist, um einen erfassten Wert einer Spannungsausgabe von der Batterie (200) und einen erfassten Wert einer Stromausgabe von der Batterie (200) zu erfassen; und
   eine Berechnungseinheit (120), die konfiguriert ist, einen Innenwiderstand der Batterie (200) und einen Gesundheitszustand der Batterie (200) unter Verwendung einer Differenz zu schätzen, die eine zeitliche Änderung der Spannung anzeigt, wobei
   die Berechnungseinheit (120) als die Differenz eine erste Differenz zwischen der Spannung zu einem ersten Startzeitpunkt nach einem Endzeitpunkt, wenn das Laden oder Entladen der Batterie (200) beendet ist, und der Spannung zu einem ersten Zeitpunkt erfasst, wenn eine erste Periode nach dem ersten Startzeitpunkt verstreicht,
   **dadurch gekennzeichnet, dass**
   die Berechnungseinheit (120) als die Differenz eine zweite Differenz zwischen der Spannung zu einem zweiten Startzeitpunkt nach dem ersten Zeitpunkt und der Spannung zu einem zweiten Zeitpunkt erfasst, wenn eine zweite Periode nach dem zweiten Startzeitpunkt verstreicht, die Berechnungseinheit (120) Beziehungsdaten erfasst, die eine Beziehung zwischen der ersten Differenz und dem Innenwiderstand beschreiben und eine Beziehung zwischen der zweiten Differenz und dem Gesundheitszustand beschreiben,
   die Berechnungseinheit (120) den Innenwiderstand unter Verwendung der ersten Differenz schätzt, um auf die Beziehungsdaten Bezug zu nehmen, und
   die Berechnungseinheit (120) den Gesundheitszustand unter Verwendung der zweiten Differenz schätzt, um auf die Beziehungsdaten Bezug zu nehmen.

2. Batterieverwaltungsvorrichtung nach Anspruch 1, wobei

   in einer Spannungsänderungskurve nach einem Endzeitpunkt des Ladens oder Entladens die erste Periode ein Abschnitt von nach dem Endzeitpunkt des Ladens oder Entladens bis zu einem maximalen Punkt einer Steigungsänderungsrate der Spannungsänderungskurve ist, und
   die zweite Periode ein Abschnitt von dem maximalen Punkt der Steigungsänderungsrate bis zu einem Punkt ist, an dem sich eine Änderung der Steigung der Spannungsänderungskurve asymptotisch einem konstanten Wert nähert.

3. Batterieverwaltungsvorrichtung nach Anspruch 1, wobei

   die Beziehungsdaten einen Innenwiderstandsparameter beschreiben, der eine Innenwiderstandsfunktion definiert, die die Beziehung zwischen dem Innenwiderstand und der ersten Differenz darstellt,
   der Innenwiderstandsparameter Folgendes beinhaltet:

   einen Innenwiderstand-Temperatur-Parameter, der gemäß einer Temperatur der Batterie (200) variiert; und
   einen Innenwiderstand-Strom-Parameter, der gemäß dem Strom variiert,
   die Beziehungsdaten den Innenwiderstand-Temperatur-Parameter für jeden Wert der Temperatur der Batterie (200) beschreiben und den Innenwiderstand-Strom-Parameter für jeden Wert des Stroms beschreiben, und
   die Berechnungseinheit (120) den Innenwiderstand unter Verwendung des aus den Beziehungsdaten erfassten Innenwiderstandsparameters berechnet.

**4.** Batterieverwaltungsvorrichtung nach Anspruch 1, wobei

die Beziehungsdaten einen Gesundheitszustandsparameter beschreiben, der eine Gesundheitszustandsfunktion definiert, die die Beziehung zwischen dem Gesundheitszustand und der zweiten Differenz darstellt, der Gesundheitszustandsparameter Folgendes beinhaltet:

einen Gesundheitszustand-Temperatur-Parameter, der gemäß einer Temperatur der Batterie (200) variiert; und
einen Gesundheitszustand-Strom-Parameter, der gemäß dem Strom variiert,
die Beziehungsdaten den Gesundheitszustand-Temperatur-Parameter für jeden Wert der Temperatur der Batterie (200) beschreiben und den Gesundheitszustand-Strom-Parameter für jeden Wert des Stroms beschreiben, und
die Berechnungseinheit (120) den Gesundheitszustand unter Verwendung des aus den Beziehungsdaten erfassten Gesundheitszustandsparameters berechnet.

**5.** Batterieverwaltungsvorrichtung nach Anspruch 3, wobei

die Innenwiderstandsfunktion eine Funktion ist, die die Beziehung zwischen dem Innenwiderstand und der ersten Differenz durch eine lineare Funktion der ersten Differenz darstellt,
der Innenwiderstand-Temperatur-Parameter eine Steigung der linearen Funktion für jeden Wert der Temperatur der Batterie (200) definiert,
der Innenwiderstand-Strom-Parameter einen Abschnitt der linearen Funktion für jeden Wert des Stroms definiert,
die Berechnungseinheit (120) die Steigung der linearen Funktion unter Verwendung eines Messwerts der Temperatur der Batterie (200) erfasst, um auf die Beziehungsdaten Bezug zu nehmen,
die Berechnungseinheit (120) den Abschnitt der linearen Funktion unter Verwendung eines Messwerts des Stroms erfasst, um auf die Beziehungsdaten Bezug zu nehmen, und
die Berechnungseinheit (120) den Innenwiderstand unter Verwendung der aus den Beziehungsdaten erfassten Steigung und des aus den Beziehungsdaten erfassten Abschnitts berechnet.

**6.** Batterieverwaltungsvorrichtung nach Anspruch 4, wobei

die Gesundheitszustandsfunktion eine Funktion ist, die die Beziehung zwischen dem Gesundheitszustand und der zweiten Differenz durch eine lineare Funktion der zweiten Differenz darstellt,
der Gesundheitszustand-Temperatur-Parameter eine Steigung der linearen Funktion für jeden Wert der Temperatur der Batterie (200) definiert,
der Gesundheitszustand-Strom-Parameter einen Abschnitt der linearen Funktion für jeden Wert des Stroms definiert,
die Berechnungseinheit (120) die Steigung der linearen Funktion unter Verwendung eines Messwerts der Temperatur der Batterie (200) erfasst, um auf die Beziehungsdaten Bezug zu nehmen,
die Berechnungseinheit (120) den Abschnitt der linearen Funktion unter Verwendung eines Messwerts des Stroms erfasst, um auf die Beziehungsdaten Bezug zu nehmen, und
die Berechnungseinheit (120) den Gesundheitszustand unter Verwendung der aus den Beziehungsdaten erfassten Steigung und des aus den Beziehungsdaten erfassten Abschnitts berechnet.

**7.** Batterieverwaltungsvorrichtung nach Anspruch 3, wobei

die Beziehungsdaten den Innenwiderstandsparameter für jede von einer ersten Pausenperiode, nachdem das Laden der Batterie (200) beendet ist, und einer zweiten Pausenperiode, nachdem das Entladen der Batterie (200) beendet ist, beschreiben,
die Beziehungsdaten einen Nachladeparameter beschreiben, der den Innenwiderstandsparameter in der ersten Pausenperiode definiert,
die Beziehungsdaten einen Nachentladeparameter beschreiben, der den Innenwiderstandsparameter in der zweiten Pausenperiode definiert,
die Berechnungseinheit (120) den Nachladeparameter aus den Beziehungsdaten in der ersten Pausenperiode erfasst, und
die Berechnungseinheit (120) den Nachentladeparameter aus den Beziehungsdaten in der zweiten Pausenperiode erfasst.

8. Batterieverwaltungsvorrichtung nach Anspruch 4, wobei

die Beziehungsdaten den Gesundheitszustandsparameter für jede von einer ersten Pausenperiode, nachdem das Laden der Batterie (200) beendet ist, und einer zweiten Pausenperiode, nachdem das Entladen der Batterie (200) beendet ist, beschreiben,
die Beziehungsdaten einen Nachladeparameter beschreiben, der den Gesundheitszustandsparameter in der ersten Pausenperiode definiert,
die Beziehungsdaten einen Nachentladeparameter beschreiben, der den Gesundheitszustandsparameter in der zweiten Pausenperiode definiert,
die Berechnungseinheit (120) den Nachladeparameter aus den Beziehungsdaten in der ersten Pausenperiode erfasst, und
die Berechnungseinheit (120) den Nachentladeparameter aus den Beziehungsdaten in der zweiten Pausenperiode erfasst.

9. Batterieverwaltungsvorrichtung nach Anspruch 3, wobei

die Beziehungsdaten den Innenwiderstandsparameter für jede Fertigungschargennummer der Batterie (200) beschreiben, und
die Berechnungseinheit (120) den Innenwiderstandsparameter unter Verwendung der Fertigungschargennummer der Batterie (200) erfasst, um auf die Beziehungsdaten Bezug zu nehmen.

10. Batterieverwaltungsvorrichtung nach Anspruch 4, wobei

die Beziehungsdaten den Gesundheitszustandsparameter für jede Fertigungschargennummer der Batterie (200) beschreiben, und
die Berechnungseinheit (120) den Gesundheitszustandsparameter unter Verwendung der Fertigungschargennummer der Batterie (200) erfasst, um auf die Beziehungsdaten Bezug zu nehmen.

11. Batterieverwaltungsvorrichtung nach Anspruch 1, wobei

die Batterie (200) so konfiguriert ist, dass der Strom in einer Rechteckwellenform ansteigt, wenn das Entladen beendet ist, oder der Strom in einer Rechteckwellenform abfällt, wenn das Laden beendet ist, und
die Berechnungseinheit (120) eine Variation in der Spannung, die aufgrund des Ansteigens oder des Abfallens der Rechteckwellenform verursacht wird, als mindestens einen Teil der ersten Differenz erfasst.

12. Batterieverwaltungsverfahren, das konfiguriert ist, um einen Zustand einer Batterie (200) zu verwalten, umfassend:

Erfassen eines erfassten Werts einer Spannungsausgabe von der Batterie (200) und eines erfassten Werts einer Stromausgabe von der Batterie (200); und
Schätzen eines Innenwiderstands der Batterie (200) und eines Gesundheitszustands der Batterie (200) unter Verwendung einer Differenz, die eine zeitliche Änderung der Spannung anzeigt, wobei
beim Schätzen eine erste Differenz zwischen der Spannung zu einem ersten Startzeitpunkt nach einem Endzeitpunkt, wenn das Laden oder Entladen der Batterie (200) beendet ist, und der Spannung zu einem ersten Zeitpunkt, wenn eine erste Periode nach dem ersten Startzeitpunkt verstreicht, als die Differenz erfasst wird,
**dadurch gekennzeichnet, dass**
beim Schätzen eine zweite Differenz zwischen der Spannung zu einem zweiten Startzeitpunkt nach dem ersten Zeitpunkt und der Spannung zu einem zweiten Zeitpunkt, wenn eine zweite Periode nach dem zweiten Startzeitpunkt verstreicht, als die Differenz erfasst wird,
beim Schätzen Beziehungsdaten erfasst werden, die eine Beziehung zwischen der ersten Differenz und dem Innenwiderstand beschreiben und eine Beziehung zwischen der zweiten Differenz und dem Gesundheitszustand beschreiben,
beim Schätzen der Innenwiderstand unter Verwendung der ersten Differenz geschätzt wird, um auf die Beziehungsdaten Bezug zu nehmen, und
beim Schätzen der Gesundheitszustand unter Verwendung der zweiten Differenz geschätzt wird, um auf die Beziehungsdaten Bezug zu nehmen.

13. Batterieverwaltungsvorrichtung nach Anspruch 1, wobei ein Zeitintervall zwischen dem ersten Zeitpunkt und dem zweiten Startzeitpunkt existiert.

**Revendications**

1. Dispositif de gestion de batterie pour gérer un état d'une batterie (200), comprenant :

une unité de détection (130) configurée pour acquérir une valeur détectée d'une tension délivrée par la batterie (200) et une valeur détectée d'un courant délivré par la batterie (200) ; et
une unité de calcul (120) configurée pour estimer une résistance interne de la batterie (200) et un état de santé de la batterie (200) en utilisant une différence indiquant un changement dans le temps de la tension, dans lequel l'unité de calcul (120) acquiert, en tant que différence, une première différence entre la tension à un premier instant de début après un instant de fin lorsque la charge ou la décharge de la batterie (200) est terminée et la tension à un premier instant lorsqu'une première période s'écoule après le premier instant de début,
**caractérisé en ce que**
l'unité de calcul (120) acquiert, en tant que différence, une seconde différence entre la tension à un second instant de début après le premier instant et la tension à un second instant lorsqu'une seconde période s'écoule après le second instant de début, l'unité de calcul (120) acquiert des données de relation qui décrivent une relation entre la première différence et la résistance interne et décrivent une relation entre la seconde différence et l'état de santé,
l'unité de calcul (120) estime la résistance interne en utilisant la première différence pour se référer aux données de relation, et
l'unité de calcul (120) estime l'état de santé en utilisant la seconde différence pour se référer aux données de relation.

2. Dispositif de gestion de batterie selon la revendication 1, dans lequel,

dans une courbe de changement de tension après un instant de fin de charge ou de décharge, la première période est une section depuis après l'instant de fin de charge ou de décharge jusqu'à un point maximum d'un taux de changement de pente de la courbe de changement de tension, et
la seconde période est une section depuis le point maximum du taux de changement de pente jusqu'à un point auquel un changement de pente de la courbe de changement de tension s'approche asymptotiquement d'une valeur constante.

3. Dispositif de gestion de batterie selon la revendication 1, dans lequel

les données de relation décrivent un paramètre de résistance interne qui définit une fonction de résistance interne représentant la relation entre la résistance interne et la première différence,
le paramètre de résistance interne comprend :

un paramètre de température de résistance interne qui varie en fonction d'une température de la batterie (200) ; et
un paramètre de courant de résistance interne qui varie en fonction du courant,
les données de relation décrivent le paramètre de température de résistance interne pour chaque valeur de la température de la batterie (200) et décrivent le paramètre de courant de résistance interne pour chaque valeur du courant, et
l'unité de calcul (120) calcule la résistance interne en utilisant le paramètre de résistance interne acquis à partir des données de relation.

4. Dispositif de gestion de batterie selon la revendication 1, dans lequel

les données de relation décrivent un paramètre d'état de santé qui définit une fonction d'état de santé représentant la relation entre l'état de santé et la seconde différence,
le paramètre d'état de santé comprend :

un paramètre de température d'état de santé qui varie en fonction d'une température de la batterie (200) ; et
un paramètre de courant d'état de santé qui varie en fonction du courant,
les données de relation décrivent le paramètre de température d'état de santé pour chaque valeur de la température de la batterie (200) et décrivent le paramètre de courant d'état de santé pour chaque valeur du courant, et

l'unité de calcul (120) calcule l'état de santé en utilisant le paramètre d'état de santé acquis à partir des données de relation.

5. Dispositif de gestion de batterie selon la revendication 3, dans lequel

la fonction de résistance interne est une fonction représentant la relation entre la résistance interne et la première différence par une fonction linéaire de la première différence,

le paramètre de température de résistance interne définit une pente de la fonction linéaire pour chaque valeur de la température de la batterie (200),

le paramètre de courant de résistance interne définit une interception de la fonction linéaire pour chaque valeur du courant,

l'unité de calcul (120) acquiert la pente de la fonction linéaire en utilisant une valeur mesurée de la température de la batterie (200) pour se référer aux données de relation,

l'unité de calcul (120) acquiert l'interception de la fonction linéaire en utilisant une valeur mesurée du courant pour se référer aux données de relation, et

l'unité de calcul (120) calcule la résistance interne en utilisant la pente acquise à partir des données de relation et l'interception acquise à partir des données de relation.

6. Dispositif de gestion de batterie selon la revendication 4, dans lequel

la fonction d'état de santé est une fonction représentant la relation entre l'état de santé et la seconde différence par une fonction linéaire de la seconde différence,

le paramètre de température d'état de santé définit une pente de la fonction linéaire pour chaque valeur de la température de la batterie (200),

le paramètre de courant d'état de santé définit une interception de la fonction linéaire pour chaque valeur du courant,

l'unité de calcul (120) acquiert la pente de la fonction linéaire en utilisant une valeur mesurée de la température de la batterie (200) pour se référer aux données de relation,

l'unité de calcul (120) acquiert l'interception de la fonction linéaire en utilisant une valeur mesurée du courant pour se référer aux données de relation, et

l'unité de calcul (120) calcule l'état de santé en utilisant la pente acquise à partir des données de relation et l'interception acquise à partir des données de relation.

7. Dispositif de gestion de batterie selon la revendication 3, dans lequel

les données de relation décrivent le paramètre de résistance interne pour chacune d'une première période de pause après que la charge de la batterie (200) est terminée et d'une seconde période de pause après que la décharge de la batterie (200) est terminée,

les données de relation décrivent un paramètre de post-charge qui définit le paramètre de résistance interne dans la première période de pause,

les données de relation décrivent un paramètre de post-décharge qui définit le paramètre de résistance interne dans la seconde période de pause,

l'unité de calcul (120) acquiert le paramètre de post-charge à partir des données de relation dans la première période de pause, et

l'unité de calcul (120) acquiert le paramètre de post-décharge à partir des données de relation dans la seconde période de pause.

8. Dispositif de gestion de batterie selon la revendication 4, dans lequel

les données de relation décrivent le paramètre d'état de santé pour chacune d'une première période de pause après que la charge de la batterie (200) est terminée et d'une seconde période de pause après que la décharge de la batterie (200) est terminée,

les données de relation décrivent un paramètre de post-charge qui définit le paramètre d'état de santé dans la première période de pause,

les données de relation décrivent un paramètre de post-décharge qui définit le paramètre d'état de santé dans la seconde période de pause,

l'unité de calcul (120) acquiert le paramètre de post-charge à partir des données de relation dans la première période de pause, et

l'unité de calcul (120) acquiert le paramètre de post-décharge à partir des données de relation dans la seconde période de pause.

**9.** Dispositif de gestion de batterie selon la revendication 3, dans lequel

les données de relation décrivent le paramètre de résistance interne pour chaque numéro de lot de fabrication de la batterie (200), et

l'unité de calcul (120) acquiert le paramètre de résistance interne en utilisant le numéro de lot de fabrication de la batterie (200) pour se référer aux données de relation.

**10.** Dispositif de gestion de batterie selon la revendication 4, dans lequel

les données de relation décrivent le paramètre d'état de santé pour chaque numéro de lot de fabrication de la batterie (200), et

l'unité de calcul (120) acquiert le paramètre d'état de santé en utilisant le numéro de lot de fabrication de la batterie (200) pour se référer aux données de relation.

**11.** Dispositif de gestion de batterie selon la revendication 1, dans lequel

la batterie (200) est configurée de sorte que le courant monte dans une forme d'onde rectangulaire lorsque la décharge est terminée, ou le courant chute dans une forme d'onde rectangulaire lorsque la charge est terminée, et

l'unité de calcul (120) acquiert une variation de la tension provoquée en raison de la montée ou de la chute de la forme d'onde rectangulaire en tant qu'au moins une partie de la première différence.

**12.** Procédé de gestion de batterie configuré pour gérer un état d'une batterie (200), comprenant :

l'acquisition d'une valeur détectée d'une tension délivrée par la batterie (200) et d'une valeur détectée d'un courant délivré par la batterie (200) ; et

l'estimation d'une résistance interne de la batterie (200) et d'un état de santé de la batterie (200) en utilisant une différence indiquant un changement dans le temps de la tension, dans lequel

dans l'estimation, une première différence entre la tension à un premier instant de début après un instant de fin lorsque la charge ou la décharge de la batterie (200) est terminée et la tension à un premier instant lorsqu'une première période s'écoule après le premier instant de début est acquise en tant que différence,

**caractérisé en ce que**

dans l'estimation, une seconde différence entre la tension à un second instant de début après le premier instant et la tension à un second instant lorsqu'une seconde période s'écoule après le second instant de début est acquise en tant que différence,

dans l'estimation, des données de relation qui décrivent une relation entre la première différence et la résistance interne et décrivent une relation entre la seconde différence et l'état de santé sont acquises,

dans l'estimation, la résistance interne est estimée en utilisant la première différence pour se référer aux données de relation, et

dans l'estimation, l'état de santé est estimé en utilisant la seconde différence pour se référer aux données de relation.

**13.** Dispositif de gestion de batterie selon la revendication 1, dans lequel un intervalle de temps existe entre le premier instant et le second instant de début.

FIG. 1

# FIG. 2

# FIG. 3

SOH, Ri

100

COMMUNICATION UNIT — 110

140

CALCULATION UNIT — 120

DETECTION UNIT — 130

V, I, T

200 — BATTERY

# FIG. 4

# FIG. 5

# FIG. 6

# FIG. 7

# FIG. 8

## FIG. 9

141

| Rest after charge | | | | Rest after discharge | | | |
|---|---|---|---|---|---|---|---|
| I | c_Ri_I_1 | c_Ri_I_2 | ... | I | c_Ri_I_1 | c_Ri_I_2 | ... |
| I1 | ... | ... | ... | I1 | ... | ... | ... |
| I2 | ... | ... | ... | I2 | ... | ... | ... |
| ... | ... | ... | ... | ... | ... | ... | ... |

| Rest after charge | | | | Rest after discharge | | | |
|---|---|---|---|---|---|---|---|
| T(K) | c_Ri_T_1 | c_Ri_T_2 | ... | T(K) | c_Ri_T_1 | c_Ri_T_2 | ... |
| T1 | ... | ... | ... | T1 | ... | ... | ... |
| T2 | ... | ... | ... | T2 | ... | ... | ... |
| ... | ... | ... | ... | ... | ... | ... | ... |

| Rest after charge | | | | Rest after discharge | | | |
|---|---|---|---|---|---|---|---|
| I | c_SOH_I_1 | c_SOH_I_2 | ... | I | c_SOH_I_1 | c_SOH_I_2 | ... |
| I1 | ... | ... | ... | I1 | ... | ... | ... |
| I2 | ... | ... | ... | I2 | ... | ... | ... |
| ... | ... | ... | ... | ... | ... | ... | ... |

| Rest after charge | | | | Rest after discharge | | | |
|---|---|---|---|---|---|---|---|
| T(K) | c_SOH_T_1 | c_SOH_T_2 | ... | T(K) | c_SOH_T_1 | c_SOH_T_2 | ... |
| T1 | ... | ... | ... | T1 | ... | ... | ... |
| T2 | ... | ... | ... | T2 | ... | ... | ... |
| ... | ... | ... | ... | ... | ... | ... | ... |

# FIG. 10

141

| Rest after charge | | | | Rest after discharge | | | |
|---|---|---|---|---|---|---|---|
| I | c_Ri_I_1 | c_Ri_I_2 | ... | I | c_Ri_I_1 | c_Ri_I_2 | ... |
| I1 | ... | ... | ... | I1 | ... | ... | ... |
| I2 | ... | ... | ... | I2 | ... | ... | ... |
| ... | ... | ... | ... | ... | ... | ... | ... |

| Rest after charge | | | | Rest after discharge | | | |
|---|---|---|---|---|---|---|---|
| T(K) | c_Ri_T_1 | c_Ri_T_2 | ... | T(K) | c_Ri_T_1 | c_Ri_T_2 | ... |
| T1 | ... | ... | ... | T1 | ... | ... | ... |
| T2 | ... | ... | ... | T2 | ... | ... | ... |
| ... | ... | ... | ... | ... | ... | ... | ... |

| Rest after charge | | | | Rest after discharge | | | |
|---|---|---|---|---|---|---|---|
| I | c_SOH_I_1 | c_SOH_I_2 | ... | I | c_SOH_I_1 | c_SOH_I_2 | ... |
| I1 | ... | ... | ... | I1 | ... | ... | ... |
| I2 | ... | ... | ... | I2 | ... | ... | ... |
| ... | ... | ... | ... | ... | ... | ... | ... |

| Rest after charge | | | | Rest after discharge | | | |
|---|---|---|---|---|---|---|---|
| T(K) | c_SOH_T_1 | c_SOH_T_2 | ... | T(K) | c_SOH_T_1 | c_SOH_T_2 | ... |
| T1 | ... | ... | ... | T1 | ... | ... | ... |
| T2 | ... | ... | ... | T2 | ... | ... | ... |
| ... | ... | ... | ... | ... | ... | ... | ... |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010175484 A
- JP 2017129401 A
- JP 2013088148 A
- JP 2014025738 A
- JP 2018205309 A